Europäisches Patentamt

European Patent Office

Office européen des brevets

(11) Numéro de publication: **0 240 061 B1**

## (12) FASCICULE DE BREVET EUROPEEN

(45) Date de publication de fascicule du brevet: **17.06.92**　(51) Int. Cl.5: **H03K 19/096**

(21) Numéro de dépôt: **87200500.4**

(22) Date de dépôt: **19.03.87**

(54) **Porte logique MOS du type domino.**

(30) Priorité: **28.03.86 FR 8604504**

(43) Date de publication de la demande:
**07.10.87 Bulletin 87/41**

(45) Mention de la délivrance du brevet:
**17.06.92 Bulletin 92/25**

(84) Etats contractants désignés:
**DE FR GB IT NL**

(56) Documents cités:
**FR-A- 1 504 328**
**GB-A- 2 120 034**

**IBM TECHNICAL DISCLOSURE BULLETIN, vol. 27, no. 11, avril 1985, pages 6789-6790, New York, US; "Single-ended cascode voltage switch logic circuit"**

(73) Titulaire: **PHILIPS COMPOSANTS**
**117, quai du Président Roosevelt**
**F-92130 Issy les Moulineaux(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Guerin, Armand Société Civile S.P.I.D.**
**156, Boulevard Haussmann**
**F-75008 Paris(FR)**
Inventeur: **Lanfranca, Michel Société Civile S.P.I.D.**
**156, Boulevard Haussmann**
**F-75008 Paris(FR)**

(74) Mandataire: **Charpail, François et al**
**Société Civile S.P.I.D. 156, Boulevard Haussmann**
**F-75008 Paris(FR)**

## Description

La présente invention a pour objet une porte logique MOS du type domino comprenant un réseau logique comportant des transistors MOS d'un premier type de conduction recevant des données d'entrée et raccordé à une première et une deuxième source de tension à travers le trajet source-drain respectivement d'un transistor MOS de précharge d'un deuxième type de conduction et d'un transistor MOS de validation du premier type de conduction, l'électrode de porte (ou gate) de chacun desdits transistors étant cadencée par un signal d'horloge qui, lorsqu'il est à un premier niveau logique, précharge à un niveau de précharge une sortie du circuit, et lorsqu'il est à un deuxième niveau logique, autorise la lecture d'un signal logique de sortie.

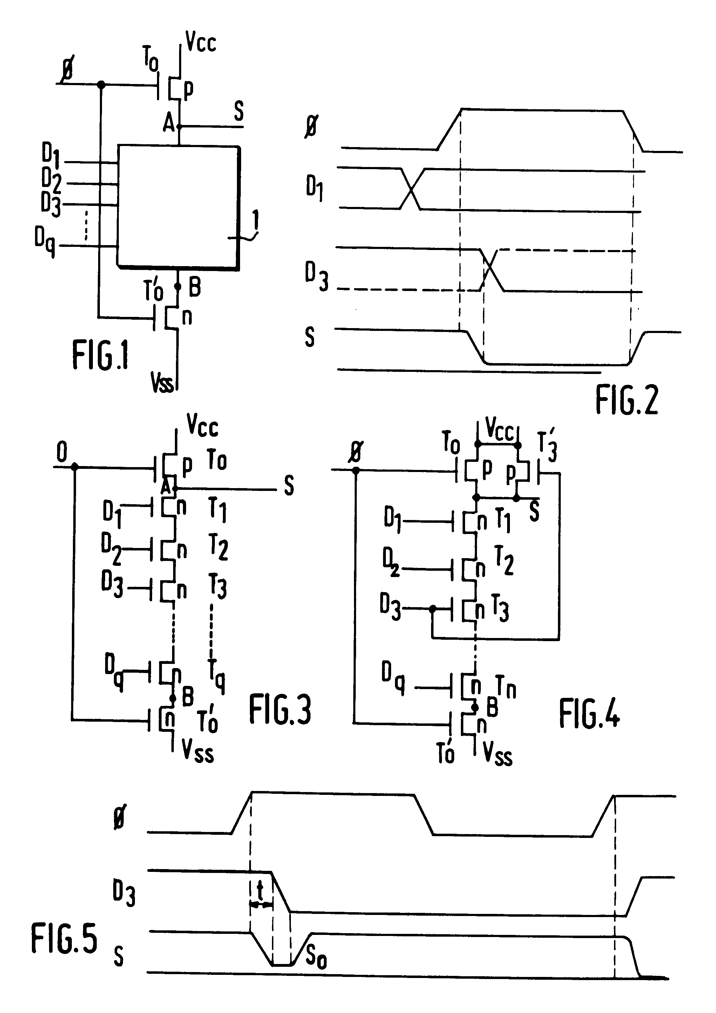

Dans la publication IBM Technical Disclosure vol 27 n° 11 avril 1985 p.6789/90 et le brevet FR-A-1 504 328 qui décrivent un dispositif du type précité, le signal d'horloge est utilisé pour réaliser une précharge de la sortie de la porte logique. En effet, lorsque le signal d'horloge est au niveau bas, ledit transistor de précharge, ici du type p. MOS est conducteur et ledit transistor de validation, ici du type n - MOS est bloqué, ce qui fait que la sortie de la porte logique est préchargée au niveau haut. Lorsque le signal d'horloge est au niveau haut, le transistor de validation n - MOS est conducteur et le transistor de précharge p - MOS est bloqué. Dans ce cas, si le réseau logique est dans un état conducteur, la sortie de la porte logique passe au niveau bas, alors qu'elle reste au niveau haut si le réseau logique n'est pas dans un état conducteur. Le fonctionnement correct de la porte logique MOS implique que les données soient à chaque coup d'horloge stabilisées avant que le signal d'horloge ne remonte au niveau haut. En effet, si le changement d'état d'une donnée arrive en retard et a pour conséquence de maintenir pendant un certain temps le réseau logique à un état conducteur erroné, l'effet de la précharge de la sortie à l'état haut peut être en tout en partie perdu, et la sortie de la porte logique, rester au niveau bas alors que le réseau logique est redevenu non conducteur. Cette même antériorité décrit également une porte logique à "symétrie complémentaire" (fig.1 et 2) dont toutes les portes du réseau logique sont complémentées, ce qui permet une faible dissipation thermique en régime permanent.

La présente invention a pour objet une porte logique du type mentionné en premier lieu et dont la sortie est protégée contre ces défauts lorsqu'une entrée bien définie ou bien certaines entrées bien définies ne sont stabilisées qu'après la transition du signal d'horloge, consistant dans le cas précité en une remontée au niveau haut du signal d'horloge, et qui autorise la lecture d'un signal logique de sortie.

Dans ce but, la porte logique selon l'invention est caractérisée en ce que pour éviter une décharge non souhaitée du niveau préchargé pouvant être induite par au moins une donnée d'entrée stabilisée tardivement, c'est-à-dire seulement après la montée au deuxième niveau logique du signal d'horloge, elle comporte, en parallèle avec le trajet source-drain du transistor de précharge, sous-réseau p. MOS du deuxième type de conduction et comprenant moins de transistors que le réseau logique et comportant le complément logique au moins du ou des transistor(s) du réseau logique MOS recevant la ou lesdites donnée(s) d'entrée stabilisée(s) tardivement, le sous-réseau MOS recevant la ou les donnée(s) d'entrée stabilisée(s) tardivement.

Selon un mode de réalisation préféré, le réseau logique par exemple n - MOS correspond à une fonction ET à q entrées et comporte à cet effet un nombre q de transistors logiques, par exemple n - MOS, en série avec le transistor de précharge et le transistor de validation, et pour x données d'entrées stabilisées tardivement (avec x<q), le sous-réseau dans cet exemple p - MOS comporte x transistors logiques, dans cet exemple également p - MOS, en parallèle avec le transistor de précharge et recevant chacun sur son électrode de porte une desdites données d'entrée stabilisées tardivement.

L'invention sera mieux comprise à la lecture de la description qui va suivre, donnée à titre d'exemple non limitatif en liaison avec les dessins qui représentent :

La figure 1, une porte logique MOS du type domino de l'art antérieur.

la figure 2, le phénomène de décharge intempestive de la sortie lorsque une ou plusieurs données d'entrée sont stabilisées tardivement.

La figure 3 représente une porte ET multiple du type domino de l'art antérieur et la figure 4, une porte du même type modifiée selon l'invention dans le cas où une donnée $D_1$ est présente tardivement, la figure 5 montrant la chronologie des signaux obtenus.

Et les figures 6 à 9 représentent des variantes de portes logiques conformes à l'invention.

Selon la figure 1, une porte logique MOS du type connu sous la dénomination de domino, comporte un premier transistor p. MOS $T_0$ de précharge dont le drain est connecté à une source de tension d'alimentation positive $V_{cc}$ et la source à une première borne logique d'un réseau logique n - MOS 1, ainsi qu'un deuxième transistor n MOS $T'_0$ de validation dont le drain est connecté à une deuxième borne logique B du réseau logique 1 et dont la source est connectée à une source de tension négative VSS. Le réseau logique 1 reçoit à ses entrées des données $D_1...D_q$ qui vont rendre le trajet AB conducteur ou non selon les valeurs qu'elles vont prendre. La borne logique A constitue la sortie S de la porte logique.

Les portes des transistors $T_0$ et $T'_0$ reçoivent des signaux d'horloge 0. Lorsque le signal 0 est à son niveau bas, le transistor $T_0$ est conducteur et le transistor $T'_0$ est bloqué ce qui fait que la sortie S de la porte logique est au niveau haut, c'est-à-dire pratiquement $V_{cc}$, que le trajet AB 1 soit ou non conducteur. En d'autres termes, la sortie S est préchargée au niveau haut.

Par son principe même, cette porte logique ne peut fonctionner correctement que lorsque les données d'entrées sont stabilisées avant que le signal d'horloge 0 soit stabilisé. En effet, si une au moins des données $D_1$ ...Dq, par exemple $D_3$ transite tardivement de l'état haut à l'état bas, (voir figure 2) le trajet AB peut se trouver momentanément conducteur et décharger en tout ou partie le niveau préchargé alors qu'après stabilisation, le trajet AB est non conducteur. Il en résulte donc une perte totale ou partielle de la précharge et la présence d'un signal S pouvant être erroné. A la figure 2, on obtient en sortie un niveau bas alors qu'on aurait dû lire un niveau haut.

Les figures 3 à 5 illustrent comment il est possible de remédier à ce défaut dans le cas d'une porte ET à entrées multiples recevant des signaux logiques d'entrée $D_1...D_q$. On suppose que le signal logique $D_3$ se stabilise tardivement.

La porte ET multiple de l'art antérieur (Fig. 3) comporte entre les points A et B le réseau logique 1 constitué par q transistors n MOS $T_1...Tq$ dotn les trajets drain-source sont en série et qui reçoivent chacun sur leur porte une des données d'entrée $D_1...Dq$.

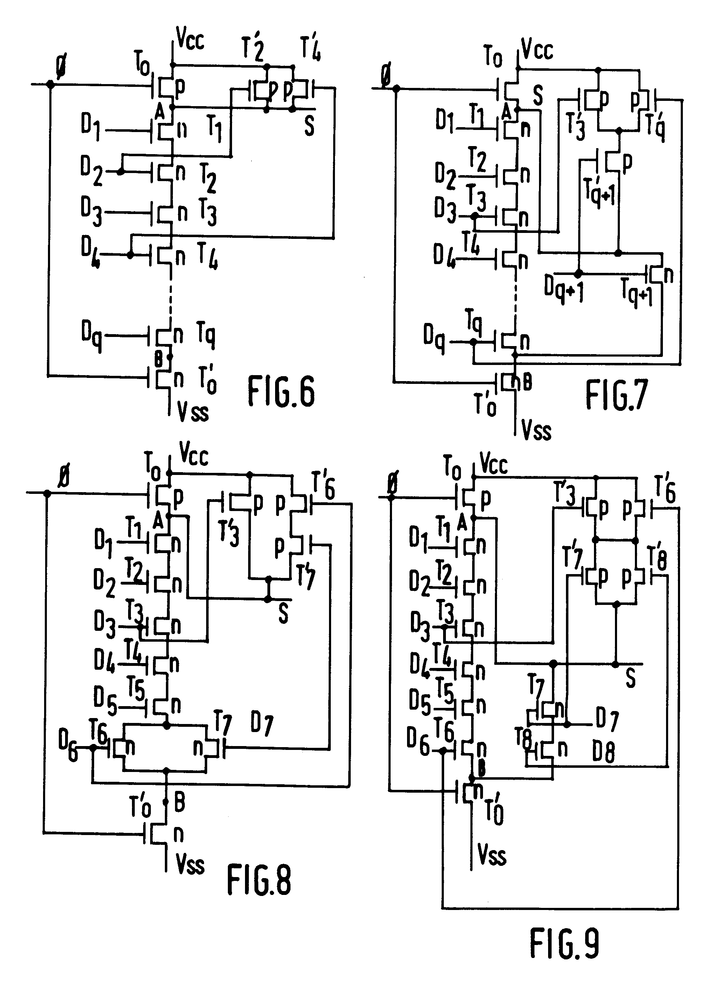

Un transistor $T'_3$ du type p - MOS (Fig 4) a son trajet source-drain connecté en parallèle sur celui du transistor $T_0$ et reçoit sur sa porte le signal logique $D_3$. La chronologie des signaux est réprésentée à la figure 5. Supposons que les signaux d'entrée $D_1$, $D_2$, $D_3...Dq$ soient au niveau haut rendant donc le trajet AB conducteur et que seul $D_3$ commute du niveau haut au niveau bas. Comme $D_3$ se stabilise par hypothèse seulement après que le signal d'horloge 0 soit remonté au niveau haut, le trajet AB reste conducteur pendant un court instant t alors que le transistor $T'_0$ est également conducteur. Il en résulte une partie partielle ou même totale de la précharge. Le signal de sortie S se trouve alors à un niveau $S_0$ proche du niveau bas. Une fois que la donnée $D_3$ est stabilisée, le transistor $T_3$ est bloqué, et le trajet AB est non conducteur, alors que le transistor $T'_3$ devient passant. De ce fait, la sortie S revient au niveau haut , ce qui corrige le niveau de la sortie.

Si on suppose que la donnée $D_3$ passe ultérieurement au niveau haut, le transistor $T_3$ devient conducteur et le transistor $T'_3$ se bloque. La sortie S passe au niveau bas avec un retard t' dû au fait que la donnée $D_3$ passe au niveau haut après que le signal d'horloge 0 soit lui-même passé au niveau haut. Le niveau en sortie S est donc correct, mais n'est disponible qu'après le retard t'.

A la figure 6, on suppose maintenant que la porte ET de la figure 3 comporte deux données d'entrée stabilisées tardivement, à savoir $D_2$ et $D_4$. La compensation de la perte possible de la précharge est réalisée en mettant en parallèle avec le transistor $T_0$ un sous réseau de type p complémentaire du montage en série des deux transistors $T_2$ et $T_4$. A cet effet, le trajet source-drain de deux transistors p -MOS $T'_2$ et $T'_4$ est mis en parallèle avec le trajet source-drain du transistor $T_0$, la porte des transistors $T'_2$ et $T'_4$ recevant respectivement les données d'entrées $D_2$ et $D_4$. Lorsque l'état logique de la porte ET est tel qu'une transition d'un niveau haut au niveau bas de l'un ou l'autre des données d'entrée $D_2$ et $D_4$ est susceptible de rendre le trajet AB conducteur de manière intempestive entraînant une perte partielle ou totale de précharge, selon le cas l'un ou l'autre des transistors $T'_2$ ou $T'_4$ ou bien les deux ensemble permettent une remontée de la sortie S au niveau haut dans des conditions analogues à celles décrites aux figures 4 et 5.

La figure 7 correspond à la fonction logique $(D_1 . D_2 . D_3...Dq) + Dq + 1$. La porte logique comprend à cet effet entre les points A et B le sous-réseau série des transistors $T_1$, $T_2...Tq$ de type n - MOS en série comme dans la figure 3 et recevant sur leur porte les données d'entrée respectivement $D_1$, $D_2...$ Dq. En parallèle avec le sous-réseau série précité est connecté le trajet source-drain d'un transistor n-MOS Tq + 1 dont la porte reçoit la donnée d'entrée D q + 1. On suppose que les données d'entrée $D_3$ et Dq se stabilisent tardivement. En parallèle avec le trajet source-drain du transistor $T_0$, sont connectés successivement à partir de la borne d'alimentation à la tension positive $V_{cc}$ les trajets mis en parallèle de deux transistors p. MOS $T'_3$ et T'q recevant sur leur porte les données d'entrée respectivement $T'_3$ et $T'_9$ en série avec un transistor p. MOS T'q + 1 recevant sur sa porte la donnée d'entrée D q + 1. Lorsque Dq + 1 est au niveau bas, le transistor T q + 1 bloqué et le transistor T' q + 1 est passant le circuit fonctionne comme dans le cas de la figure 6. Par contre, lorsque D q + 1 est au niveau haut, le transistor T q + 1 est passant est la sortie S en mode lecture est au niveau bas, alors que le transitor T' q + 1 est bloqué et enpêche tout court-circuit entre les tensions d'alimentation $V_{cc}$ et $V_{ss}$ quel que soit l'état passant ou non des transistors

T′₃ et T′q, lorsque le transistor T′₀ est conducteur (0 au niveau haut).

La figure 8 illustre le cas de la fonction logique $D_1 . D_2 . D_3 . D_4 . D_5 . (D_6 + D_7)$. Entre les bornes A et B sont connectés en série les trajets source-drain de cinq transistors n - MOS $T_1$ à $T_5$ recevant à leur porte respectivement les données d'entrée $D_1$ à $D_5$, eux-mêmes en série avec les trajets source-drain mis en parallèle de deux transistors $T_6$ et $T_7$.

On suppose que les données d'entrée $D_3$ et $D_6$ sont stabilisées tardivement. Le sous-réseau complémentaire de correction comprend alors en parallèle sur le trajet source-drain du transistor $T_0$ deux branches parallèles, l'une comprenant le trajet source-drain d'un transistor p - MOS $T′_3$ dont la porte reçoit la donnée d'entrée $D_3$ et l'autre les trajets source-drain en série de deux transistors p - MOS $T′_6$ et $T′_7$ dont la porte reçoit les données d'entrée respectivement $D_6$ et $D_7$.

Lorsque la donnée d'entrée $D_7$ est au niveau bas, le transistor $T_7$ est bloqué et le transistor $T′_7$ est passant. Tout se passe de manière analogue au cas de la figure 6 (q = 6). Lorsque la donnée d'entrée $D_7$ est au niveau haut, le transistor $T_7$ est passant et le transistor $T′_7$ est bloqué. On évite ainsi toute possibilité de court-circuit entre les tensions d'alimentation position et négative $V_{cc}$ et $V_{ss}$.

La figure 9 illustre le cas de la fonction logique $(T_1 . T_2 . T_3 . T_4 . T_5 . T_6) + (T_7 . T_8 .)$.

La porte logique comporte à cet effet entre les bornes A et B deux branches série en parallèle. La première branche série comporte les trajets source-drain de six transistors n - MOS $T_1$ à $T_6$ dont les portes reçoivent respectivement les données d'entrée $D_1$ à $D_6$. La deuxième branche série comporte les trajets source-drain de deux transistors n - MOS $T_7$ et $T_8$ dont les portes reçoivent respectivement les données d'entrée $D_7$ et $D_8$. On suppose que les données $D_3$ et $D_6$ sont stabilisées tardivement. Le sous-réseau de compensation de type p - MOS connecté en parallèle sur le trajet source-drain du transistor $T_0$ est le réseau complémentaire en p - MOS du sous réseau fictif n - MOS constitué par les transistors $T_3$ $T_6$ $T_7$ et $T_8$, en faisant abstraction de transistors $T_1$, $T_2$, $T_4$ et $T_5$. Le sous-réseau p - MOS comporte à cet effet deux groupes de deux transistors p - MOS en parallèle, ces deux groupes étant connectés en série. Le premier groupe comporte les trajets source-drain de deux transistors $T′_3$ et $T′_6$ dont les portes reçoivent respectivmeent les données d'entrée $D_3$ et $D_6$. On suppose que les données d'entrée $D_3$ et $D_6$ se stabilisent tardivement. Lorsque les données $D_7$ et $D_8$ ne sont pas simultanément à l'état haut, la deuxième branche série est bloquée et tout se passe de manière analogue au cas de la figure 6 (9 = 6).

Lorsque les données $D_7$ et $D_8$ sont simultanément à l'état haut, la deuxième branche série est conductrice, et les transistors $T′_7$ et $T′_8$ sont bloqués ce qui empêche toute possibilité de court-circuit entre $V_{cc}$ et $V_{ss}$ lorsque $T′_3$ et $T′_0$ se trouvent simultanément conducteurs.

**Revendications**

1. Porte logique MOS du type domino comprenant un réseau logique comportant des transistors MOS d'un premier type de conduction recevant des données d'entrée et raccordé à une première et une deuxième source de tension à travers le trajet source-drain respectivement d'un transistor MOS de précharge et d'un transistor MOS de validation, respectivement du deuxième et du premier type de conduction, l'électrode de porte de chacun desdits transistors étant cadencée par un signal d'horloge qui, lorsqu'il est à un premier niveau logique, précharge à un niveau de précharge une sortie du circuit et lorsqu'il est à un deuxième niveau logique autorise la lecture d'un signal logique de sortie caractérisé en ce que, pour éviter une décharge non souhaitée du niveau préchargé, pouvant être induite par au moins une donnée d'entrée stabilisée tardivement, c'est-à-dire seulement après la montée au deuxième niveau logique du signal d'horloge, elle comporte, en parallèle avec le trajet source-drain du transistor de précharge, un sous-réseau MOS du deuxième type de conduction comprenant moins de transistors que le réseau logique et comportant le complément logique au moins du ou des transistor(s) du réseau logique MOS reçevant la ou lesdites donnée(s) d'entrée stabilisée(s) tardivement, le sous-réseau MOS recevant la ou les donnée(s) d'entrée stabilisée(s) tardivement.

2. Porte logique MOS selon la revendication 1 caractérisé en ce que le réseau logique MOS correspond à une fonction ET à q entrées et comporte à cet effet q transistors logiques MOS du premier type de conduction en série avec le transistor de précharge et le transistor de validation et en ce que, pour x données d'entrées stabilisées tardivement (avec x<q) le sous-réseau MOS comporte x transistors logiques MOS du deuxième type de conduction en parallèle avec le transistor de précharge, et recevant chacun sur son électrode de porte une desdites données d'entrée stabilisées tardivement.

3. Porte logique MOS selon une des revendications 1 ou 2 caractérisé en ce que le premier niveau logique est le niveau bas, en ce que le deuxième niveau logique est le niveau haut, en ce que le premier type de conduction est le type n et en ce que le deuxième type de conduction est le type p.

## Claims

1. A domino-type MOS logic gate including a logic network comprising MOS transistors of a first conductivity type receiving input data and being connected to a first and a second voltage source via the source-drain path of a MOS precharging transistor of a second conductivity type and of a MOS validation transistor of the first conductivity type, respectively, the gate electrode of both said transistors being clocked by a clock signal which, when it is at a first logic level, precharges an output of the circuit to a precharging level and, when it is at a second logic level, allows the reading of a logic output signal, characterized in that, in order to prevent an unwanted discharging of the precharging level in response to at least one input data being stabilised tardily, that is to say not before the clock signal has changed to the second logic level, it includes, arranged parallel to the source-drain path of the precharging transistor, a MOS sub-network of the second conductivity type which includes fewer transistors than the logic network which comprises the logic complement of at least the transistor(s) of the MOS logic network, receiving said tardily stabilised input data, the MOS sub-network receiving the tardily stabilised input data.

2. A MOS logic gate as claimed in Claim 1, characterized in that the logic network corresponds to an AND-function with q inputs and comprises for that purpose a number of q logic MOS transistors of the first conductivity type in series with the precharging transistor and the validation transistor, and for x input data stabilised tardily (where x<q) the MOS sub-network comprises x MOS logic transistors of the second conductivity type in parallel with the precharging transistor and each receiving at its respective gate electrode one of said tardily stabilised input data.

3. A MOS logic gate as claimed in Claim 1 or 2, characterized in that the first logic level is the low level, the second logic level is the high level, the first conductivity type is the n-type and the second conductivity type is the p-type.

## Patentansprüche

1. MOS-Logikgatter in Domino-Technik, das aus einem logischen Netzwerk besteht, dessen MOS-Transistoren eines ersten Leitungstyps Eingangsinformationen empfangen, und welches Netzwerk über die Source-Drain-Strecke eines MOS-Vorladetransistors bzw. eines MOS-Freigabetransistors des zweiten bzw. des ersten Leitungstyps an eine erste und zweite Spannungsquelle angeschlossen ist, wobei die Gate-Elektrode jedes der Transistoren von einem Taktsignal getaktet wird, das, sobald es sich auf dem ersten Logikpegel befindet, einen Ausgang des Logikgatters bis auf einen Vorladepegel auflädt und sobald es sich auf dem zweiten Logikpegel befindet, das Auslesen eines logischen Ausgangssignals erlaubt, dadurch gekennzeichnet, daß das Gatter zum Vermeiden einer unerwünschten Entladung des Vorladepegels, die von mindestens einer verspätet, d.h. erst nach dem Anstieg des Taktsignals zum zweiten Logikpegel, stabilisierten Eingangsinformation induziert werden kann, parallel zur Source-Drain-Strecke des Vorladetransistors ein MOS-Unternetzwerk des zweiten Leitungstyps, mit weniger Transistoren als das logische Netzwerk, enthält, und das logische Komplement mindestens des oder der Transistoren des logischen MOS-Netzwerks enthält, die die verspätet stabilisierte(n) Eingangsinformation(en) empfangen, wobei das MOS-Unternetzwerk die verspätet stabilisierte(n) Eingangsinformation(en) empfängt.

2. MOS-Logikgatter nach Anspruch 1, dadurch gekennzeichnet, daß das logische MOS-Netzwerk einer UND-Funktion mit q Eingängen entspricht und hierfür q MOS-Schalttransistoren des ersten Leitungstyps in Reihe mit dem Vorladetransistor und dem Freigabetransistor enthält, und daß für x verspätet stabilisierte Eingangsinformationen (mit x<q) das Unternetzwerk x MOS-Schalttransistoren des zweiten Leitungstyps parallel zum Vorladetransistor enthält und jeder auf seiner Gate-Elektrode eine der verspätet stabilisierten Eingangsinformationen empfängt.

3. MOS-Logikgatter nach einem der Ansprüche 1 oder 2, dadurch gekennzeichnet, daß der erste Logikpegel der niedrige Pegel und der zweite Logikpegel der hohe Pegel ist, und daß der erste Leitungstyp vom Typ n und der zweite Leitungstyp vom Typ p ist.

FIG.1

FIG.2

FIG.3

FIG.4

FIG.5

FIG.6

FIG.7

FIG.8

FIG.9